# EUROPEAN PATENT APPLICATION

(11) **EP 2 579 344 A1**
(43) Date of publication of application: **10.04.2013**
(21) Application number: 11786058.5
(22) Date of filing: 21.05.2011
(51) Int. Cl.: H01L 33/48, H01L 33/62, H01L 33/64

(54) **CHIP LIGHT EMITTING DIODE STRUCTURE ON BOARD**

(30) Priority: 28.05.2010 CN 201020206881 U
(71) Applicant: JingDeZhen Fared Technology Co., Ltd, Ceramic Industrial Park Jingdezhen City, 333000 Jiangxi (CN)
(72) Inventor: CHEN, Jeong-Shiun, Jiangxi 333000 (CN)
(74) Representative: Gee, Steven William
(86) International application number: PCT/CN2011/074472
(87) International publication number: WO 2011/147286

(57) **Abstract**

A chip-on-board (COB) LED structure includes a ceramic substrate, a thermally radiative heat dissipation film, a thermally conductive binding layer, an LED chip, a nano-enamel layer, a circuit layer, a plurality of electrical connection lines, a fluorescent glue and a package resin. The LED chip is bound to the thermally radiative heat dissipation film formed on the ceramic substrate by the thermally conductive binding layer, the nano-enamel layer encloses the thermally radiative heat dissipation film for electrical insulation and protection, and the circuit layer has a circuit pattern formed on the nano-enamel layer. The electrical connection lines are configured to electrically connect the LED chip to the circuit layer, the fluorescent glue is coated on the LED chip to provide the effect of fluorescence, and the package resin encloses the circuit layer, the electrical connection lines, the nano-enamel layer and the fluorescent glue.

## Description

### BACKGROUND OF THE INVENTION

### 1. Field of the Invention

The present invention generally relates to an LED (light emitting diode) structure, and more specifically to a chip-on-board (COB) LED structure.

### 2. The Prior Arts

With the trend of power saving and carbon reducing in the world, an LED has recently become one of the most important light sources to replace the traditional light bulb.

The LED structure in the prior arts generally includes an LED chip, a sapphire substrate, a silver paste, a lead frame, a base substrate, connection lines, a package resin and an aluminum heat sink. The LED chip is formed on the sapphire substrate, which is bound to the leadframe by the silver paste. The base substrate supports the leadframe. The connection lines are used for connecting the LED chip to the leadframe and the package resin, which encloses the LED chip. The leadframe usually has an extension portion to penetrate through the base substrate so as to be connected to the aluminum heat sink under the base substrate. Thus, the heat generated by the LED chip is propagated towards the aluminum heat sink by thermal conduction.

However, as the power of the LED chip continues to increase in many applications, such as the backlight module with higher intensity of light or larger size, the overall weight and volume of the final LED products becomes much heavier and larger. As a result, it is inconvenient to use. Additionally, the leadframe often causes the low yield so as to increase the cost. Therefore, it is desired to provide a new chip-on-board LED structure to implement high efficiency of heat dissipation without using any leadframe or aluminum heat sink so as to overcome the above problems in the prior arts.

### SUMMARY OF THE INVENTION

The primary objective of the present invention is to provide a chip-on-board (COB) LED structure, which includes a ceramic substrate, a thermally radiative heat dissipation film, a thermally conductive binding layer, an LED chip, a nano-enamel layer, a circuit layer, a plurality of electrical connection lines, a fluorescent glue, and a package resin.

The thermally radiative heat dissipation film is formed on the ceramic substrate, and the LED chip is bound to the thermally radiative heat dissipation film by the thermally conductive binding layer. The ceramic substrate encloses the thermally radiative heat dissipation film to provide electrical insulation and isolation for protection. The circuit layer formed on the nano-enamel layer has a circuit pattern and is connected to the LED chip by the electrical connection lines. The fluorescent glue is coated on the LED chip to provide the effect of fluorescence and the package resin encloses the circuit layer, the electrical connection lines, the nano-enamel layer and the fluorescent glue.

The circuit layer is formed by coating the thermally conductive binding layer on the nano-enamel layer and is dried such that the circuit layer consists of the thermally conductive binding layer instead of traditional copper or copper alloy and therefore, it is convenient to form the circuit just by the process of coating without the traditional process of photolithography.

### BRIEF DESCRIPTION OF THE DRAWINGS

The present invention can be understood in more detail by reading the subsequent detailed description in conjunction with the examples and references made to the accompanying drawings, wherein:

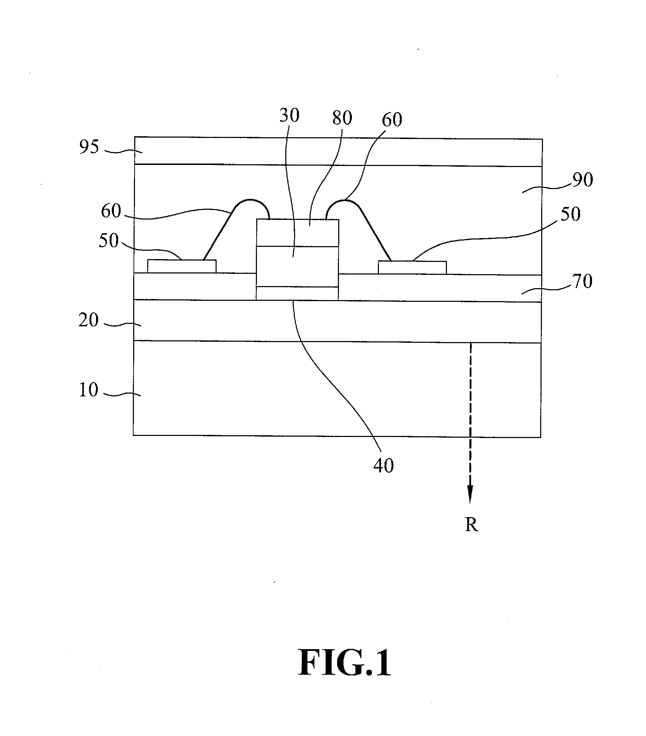

FIG. 1 is a view showing a chip-on-board LED structure according to the present invention.

### DETAILED DESCRIPTION OF THE PREFERRED EMBODIMENT

The present invention may be embodied in various forms and the details of the preferred embodiments of the present invention will be described in the subsequent content with reference to the accompanying drawings. The drawings (not to scale) show and depict only the preferred embodiments of the invention and shall not be considered as limitations to the scope of the present invention. Modifications of the shape of the present invention shall too be considered to be within the spirit of the present invention.

FIG. 1 clearly illustrates the chip-on-board LED structure according to the present invention. As shown in FIG. 1, the chip-on-board LED structure 1 of the present invention generally includes a ceramic substrate 10, a thermally radiative heat dissipation film 20, an LED chip 30, a thermally conductive binding layer 40, a circuit layer 50, a plurality of electrical connection lines 60, a nano-enamel layer 70, a fluorescent glue 80 and a package resin 90. Thus, the chip-on-board LED structure 1 is implemented as a COB structure by disposing the LED chip 30 on the ceramic substrate 10.

The ceramic substrate 10 is electrically insulated and is made from ceramic materials, consisting one of aluminum oxide, aluminum nitride, zirconium oxide and calcium fluoride.

The thermally radiative heat dissipation film 20 is formed on the ceramic substrate 10, and primarily consists of a mixture of metal and nonmetal, which consists of at least one of silver, copper, tin, aluminum, titanium, iron and antimony, and one of oxide, nitride and inorganic acid of at least one of boron and carbon. Additionally, the thermally radiative heat dissipation film 20 has a microscopic structure with crystal with a grain size between one nanometer and tens of micrometers. It is believed that the crystal of the thermally radiative heat dissipation film 20 can induce some specific lattice resonance to strongly emit corresponding thermal radiation R, such as infrared or far infrared.

The LED chip 30 is formed on the sapphire substrate (not shown) and includes at least an N type semiconductor layer, a semiconductor light emitting layer and a P type semiconductor layer (not shown), which are sequentially stacked. For instance, the N type semiconductor layer is an N type GaN (gallium nitride) layer, the semiconductor light emitting layer may consist of gallium nitride or indium gallium nitride, and the P type semiconductor layer is a P type GaN layer. Further, the P type semiconductor layer and the N type semiconductor layer are respectively connected to a positive end and a negative end of an external power source (not shown) by at least one electrical connection line. The semiconductor light emitting layer can emit light due to electron-hole recombination when the LED chip 30 is forward biased (or turned on).

The thermally conductive binding layer 40 is used to bind the LED chip 30 to the thermally radiative heat dissipation film 20. In general, the thermally conductive binding layer 40 consists of silver paste, tin paste, copper-tin alloy or gold-tin alloy.

The circuit layer 50 formed on the nano-enamel layer 70 by an electrically conductive material has a circuit pattern, which is formed by coating and drying the thermally conductive binding layer 40 on the nano-enamel layer 70.

The electrical connection lines 60 are used to connecting the LED chip 30 to the circuit layer 50. That is, the positive and negative ends of the LED chip 30 are respectively connected to the positive and negative terminals of the circuit layer 50 so as to supply power to the LED chip 30 and turn on the LED chip.

The nano-enamel layer 70 formed on the thermally radiative heat dissipation film 20 has excellent electrical insulation and encloses the LED chip 30 and the thermally radiative heat dissipation film 20 to provide electrical insulation and isolation for protection. The nano-enamel layer 70 is formed by sintering the nano-particles, consisting one of aluminum oxide, aluminum nitride, zirconium oxide and calcium fluoride.

The fluorescent glue 80 is coated on the LED chip to provide the effect of fluorescence. More specifically, the fluorescent glue 80 can convert the original light generated by the LED chip 30 into the output light within the spectrum of visible light with a specific color temperature (CT). For example, the original light with the spectrum of ultraviolet is converted into bluish or reddish light.

The package resin 90 has high transparency and excellent electrical insulation to enclose the circuit layer 50, the electrical connection lines 60, the nano-enamel layer 70 and the fluorescent glue 80. Specifically, the package resin 90 may consist of silicone or epoxy resin.

Additionally, the COB structure of the present invention may further includes a light-smoothening layer 95, which is made from transparent material and which has a hazed surface for smoothening the resulting output light by changing the traveling direction of the light emitted by the LED chip 30. The hazed surface of the light-smoothening layer 95 generally has a roughness Ra of 10 to 2,000.

One aspect of the present invention is that the ceramic substrate is used as a support substrate and the nano-enamel layer provides the interlayer insulation for the adjacent circuit layer so as to improve the electrical properties of the LED structure and increase the allowable temperature. Especially, the complexity in the design of the LED structure is thus reduced and the yield and reliability are greatly increased.

Another aspect of the present invention is that the circuit layer is formed by coating and drying the thermally conductive binding layer on the nano-enamel layer such that the circuit layer contains the thermally conductive binding layer instead of traditional copper or copper alloy and therefore, it is convenient to form the circuit just by the process of coating without the traditional process of photolithography.

A yet another aspect of the present invention is that the thermally radiative heat dissipation film produces high efficiency of heat dissipation by thermal radiation instead of traditional thermal conduction or convention so as to considerably and fastly remove the heat generated by the LED chip. Therefore, the working temperature of the LED chip is reduced and the efficiency of light emitting is increased as well as its lifetime is dramatically prolonged.

Although the present invention has been described with reference to the preferred embodiments, it will be understood that the invention is not limited to the details described thereof. Various substitutions and modifications have been suggested in the foregoing description, and others will occur to those of ordinary skill in the art. Therefore, all such substitutions and modifications are intended to be embraced within the scope of the invention as defined in the appended claims.

## Claims

1. A chip-on-board LED (Light Emitting Diode) structure, comprising:
a ceramic substrate, which is electrically insulated and which is made from ceramic material;
a thermally radiative heat dissipation film formed on the ceramic substrate to provide thermally radiative heat dissipation;
an LED chip formed on the sapphire substrate;
a thermally conductive binding layer binding the LED chip to the thermally radiative heat dissipation film;
a nano-enamel layer, which is electrically insulated and which is made from nano-particles by sintering to enclose the thermally radiative heat dissipation film;
a circuit layer with a circuit pattern formed on the nano-enamel layer, wherein the circuit layer is made from electrically conductive material;
a plurality of electrical connection lines configured to electrically connect the LED chip to the circuit layer;
a fluorescent glue coated on the LED chip to provide fluorescence; and
a package resin enclosing the circuit layer, the electrical connection lines, the nano-enamel layer and the fluorescent glue.

2. The chip-on-board LED structure as claimed in claim 1, wherein the ceramic material consists of one of aluminum oxide, aluminum nitride, zirconium oxide and calcium fluoride.

3. The chip-on-board LED structure as claimed in claim 1, wherein the LED chip consists of at least an N type semiconductor layer, a semiconductor light emitting layer and a P type semiconductor layer, which are sequentially stacked, and the semiconductor light emitting layer emitting light due to electron-hole recombination when the semiconductor light emitting layer is forward biased.

4. The chip-on-board LED structure as claimed in claim 1, wherein the circuit pattern of the circuit layer is formed by coating the thermally conductive binding layer on the nano-enamel layer and dried.

5. The chip-on-board LED structure as claimed in claim 1, wherein the nano-particles of the nano-enamel layer consist of one of aluminum oxide, aluminum nitride, zirconium oxide and calcium fluoride.

6. The chip-on-board LED structure as claimed in claim 1, wherein the package resin consists of silicone or epoxy resin.

7. The chip-on-board LED structure as claimed in claim 1, further comprising a light-smoothening layer made from transparent material and having a hazed surface, wherein the hazed surface has a roughness Ra of 10 to 2,000.
